(19) Europäisches Patentamt
European Patent Office
Office européen des brevets

(11) EP 4 194 860 A1

(12) EUROPEAN PATENT APPLICATION

(43) Date of publication:
14.06.2023 Bulletin 2023/24

(21) Application number: 22202072.9

(22) Date of filing: 18.10.2022

(51) International Patent Classification (IPC):
G01R 23/02 (2006.01)    G01R 23/15 (2006.01)
G06F 1/12 (2006.01)    H03K 5/26 (2006.01)
H03K 5/19 (2006.01)

(52) Cooperative Patent Classification (CPC):
G01R 23/02; G06F 1/12; G01R 23/15; H03K 5/19;
H03K 5/26

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 07.12.2021 US 202117543956

(71) Applicant: INTEL Corporation
Santa Clara, CA 95054 (US)

(72) Inventors:
• BEN SIMON, Yossi
20100 Karmiel (IL)
• KAHAN, Ido
Haifa 3229809 (IL)
• SHWARTZ, Ofir
3456202 Haifa (IL)
• KNOLL, Ernest
3474718 Haifa (IL)
• ADMONI, Assaf
4649131 Herzelia (IL)

(74) Representative: Maiwald GmbH
Engineering
Elisenhof
Elisenstrasse 3
80335 München (DE)

(54) CLOCK FREQUENCY RATIO MONITOR

(57) An apparatus comprising a frequency monitor circuitry to receive a first clock signal, a second clock signal and an expected frequency ratio, determine whether a ratio between the first clock signal and the second clock signal matches an expected an expected frequency ratio and generate an error signal upon a determination that the ratio between the first clock signal and the second clock signal does not match the expected frequency ratio.

FIG. 3A

EP 4 194 860 A1

**Description**

BACKGROUND OF THE DESCRIPTION

A system on chip (SOC) is an integrated circuit that integrates all components of a computer or other electronic system. These components include a central processing unit (CPU), memory, input/output (IO) ports and secondary storage, which are all included on a single substrate or microchip. SOCs are becoming more and more complex, with an increased number of components operating in a synchronous manner. Further, the components are becoming larger and more complex. As a result, valid operation of modern SoCs heavily relies on valid clock signals.

BRIEF DESCRIPTION OF THE DRAWINGS

So that the manner in which the above recited features can be understood in detail, a more particular description, briefly summarized above, may be had by reference to embodiments, some of which are illustrated in the appended drawings. It is to be noted, however, that the appended drawings illustrate only typical embodiments and are therefore not to be considered limiting of its scope, for the disclosure may admit to other equally effective embodiments.

**Figure 1** illustrates one embodiment of a computing device.
**Figure 2** illustrate embodiments of a platform.
**Figure 3A** illustrates one embodiment of a system including a frequency monitor.
**Figure 3B** illustrates another embodiment of a system including a frequency monitor.
**Figure 4** illustrates one embodiment of a frequency monitor.
**Figure 5** illustrates another embodiment of a frequency monitor.
**Figure 6A** - **6C** illustrate embodiments of waveforms.
**Figure 7** illustrates yet another embodiment of a frequency monitor.
**Figure 8** illustrates still another embodiment of a frequency monitor.
**Figure 9** is a schematic diagram of an illustrative electronic computing device.

DETAILED DESCRIPTION

In the following description, numerous specific details are set forth to provide a more thorough understanding. However, it will be apparent to one of skill in the art that the embodiments may be practiced without one or more of these specific details. In other instances, well-known features have not been described in order to avoid obscuring the embodiments.

In embodiments, a mechanism is provided to detect hacked clock signals. In such embodiments, the mechanism compares a first clock signal to a second clock signal and determines whether a ratio between the first clock signal and the second clock signal matches an expected an expected frequency ratio. In a further embodiment, generates an error signal upon a determination that the ratio between the first clock signal and the second clock signal does not match the expected frequency ratio.

References to "one embodiment", "an embodiment", "example embodiment", "various embodiments", etc., indicate that the embodiment(s) so described may include particular features, structures, or characteristics, but not every embodiment necessarily includes the particular features, structures, or characteristics. Further, some embodiments may have some, all, or none of the features described for other embodiments.

In the following description and claims, the term "coupled" along with its derivatives, may be used. "Coupled" is used to indicate that two or more elements co-operate or interact with each other, but they may or may not have intervening physical or electrical components between them.

As used in the claims, unless otherwise specified, the use of the ordinal adjectives "first", "second", "third", etc., to describe a common element, merely indicate that different instances of like elements are being referred to, and are not intended to imply that the elements so described must be in a given sequence, either temporally, spatially, in ranking, or in any other manner.

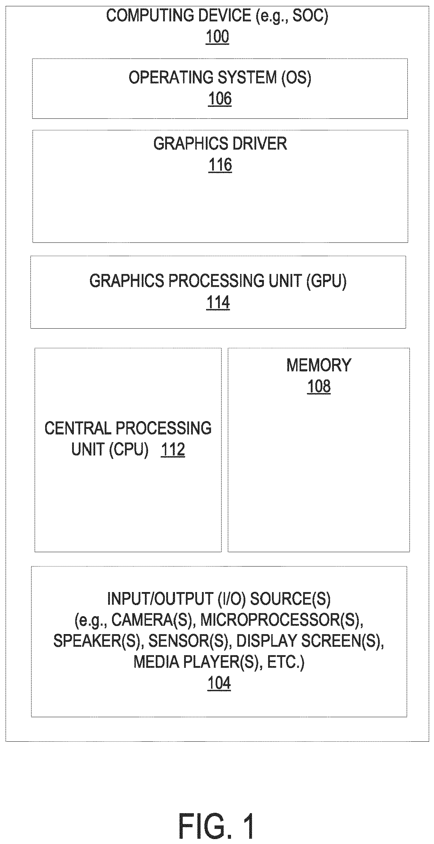

**Figure 1** illustrates one embodiment of a computing device 100. According to one embodiment, computing device 100 comprises a computer platform hosting an integrated circuit ("IC"), such as a system on a chip ("SoC" or "SOC"), integrating various hardware and/or software components of computing device 100 on a single chip. As illustrated, in one embodiment, computing device 100 may include any number and type of hardware and/or software components, such as (without limitation) graphics processing unit 114 ("GPU" or simply "graphics processor"), graphics driver 116 (also referred to as "GPU driver", "graphics driver logic", "driver logic", user-mode driver (UMD), UMD, user-mode driver framework (UMDF), UMDF, or simply "driver"), central processing unit 112 ("CPU" or simply "application processor"), memory 108, network devices, drivers, or the like, as well as input/output (I/O) sources 104, such as touchscreens, touch panels, touch pads, virtual or regular keyboards, virtual or regular mice, ports, connectors, etc. Computing device 100 may include operating system (OS) 106 serving as an interface between hardware and/or physical resources of computing device 100 and a user.

It is to be appreciated that a lesser or more equipped system than the example described above may be preferred for certain implementations. Therefore, the configuration of computing device 100 may vary from implementation to implementation depending upon numerous factors, such as price constraints, performance requirements, technological improvements, or other circumstances.

Embodiments may be implemented as any or a combination of: one or more microchips or integrated circuits interconnected using a parentboard, hardwired logic, software stored by a memory device and executed by a microprocessor, firmware, an application specific integrated circuit (ASIC), and/or a field programmable gate array (FPGA). The terms "logic", "module", "component", "engine", and "mechanism" may include, by way of example, software or hardware and/or a combination thereof, such as firmware.

Embodiments may be implemented using one or more memory chips, controllers, CPUs (Central Processing Unit), microchips or integrated circuits interconnected using a motherboard, an application specific integrated circuit (ASIC), and/or a field programmable gate array (FPGA). The term "logic" may include, by way of example, software or hardware and/or combinations of software and hardware.

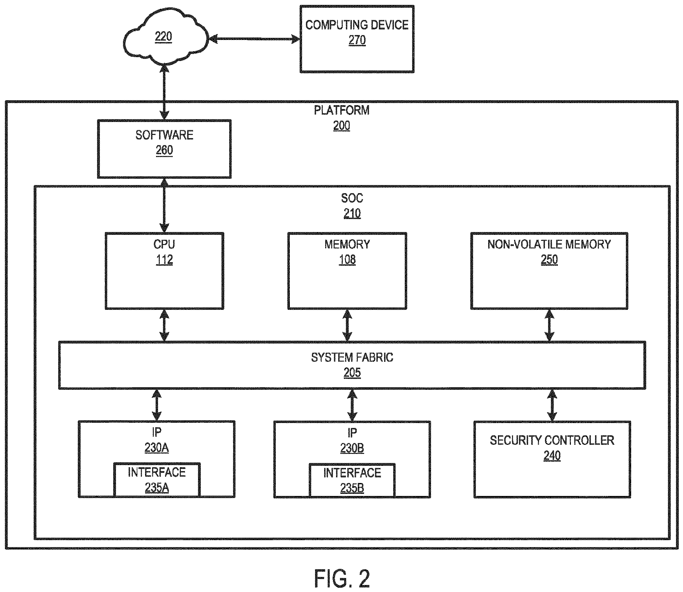

**Figure 2** illustrates one embodiment of a platform 200 including a SOC 210 similar to computing device 100 discussed above. As shown in **Figure 2,** platform 200 includes SOC 210 communicatively coupled to one or more software components 260 via CPU 112. In a further embodiment, platform 200 may also be coupled to a computing device 270 via a cloud network 220. In this embodiment, computing device 270 comprises a cloud agent that is provided access to SOC 210 via software 260.

Additionally, SOC 210 includes other computing device components (e.g., memory 108) coupled via a system fabric 205. In one embodiment, system fabric 205 comprises an integrated on-chip system fabric (IOSF) to provide a standardized on-die interconnect protocol for coupling interconnect protocol (IP) agents 230 (e.g., IP blocks 230A and 230B) within SOC 210. In such an embodiment, the interconnect protocol provides a standardized interface to enable third parties to design logic such as IP agents to be incorporated in SOC 210.

According to embodiment, IP agents 230 may include general purpose processors (e.g., in-order or out-of-order cores), fixed function units, graphics processors, I/O controllers, display controllers, etc. In such an embodiment, each IP agent 230 includes a hardware interface 235 (e.g., 235A and 235B) to provide standardization to enable the IP agent 230 to communicate with SOC 210 components. For example, in an embodiment in which IPA agent 230 is a third party visual processing unit (VPU), interface 235 provides a standardization to enable the VPU to access memory 108 via fabric 205.

SOC 210 also includes a security controller 240 that operates as a security engine to perform various security operations (e.g., security processing, cryptographic functions, etc.) for SOC 210. In one embodiment, security controller 240 comprises a cryptographic processor IP agent 230 implemented to perform the security operations. Further, SOC 210 includes a non-volatile memory 250. Non-volatile memory 250 may be implemented as a Peripheral Component Interconnect Express (PCIe) storage drive, such as a solid-state drive (SSD) or Non-Volatile Memory Express (NVMe) drives.

As discussed above, SOCs rely on valid clock signals. For example, a CPU SOC is often a target of cyber-attacks, which will increase as SOCs continue to integrate more security sensitive logic (e.g. Trusted Execution Environments), and to be used for building safety sensitive products such as autonomous cars and various robotics. While hacking an input clock may introduce fatal errors that may crash the platform, hacking may also cause internal logic marginality issues that may allow the platform to keep operating, albeit in a non-secure or unsafe manner to expose secrets or make invalid decisions. For example, malicious actors may shorten the clock cycles of an encryption unit (e.g., Advanced Encryption Standard (AES)), resulting in partial calculations of the encryption cycles; thus exposing information on a secret encryption key. Finally, others means of attacks may also occur on an integrated circuit (IC) that can result in a hacked clock signal (e.g. software, voltage, or laser attacks to modify internal clock multipliers) that causes similar damage.

According to one embodiment, a mechanism is provided within an SOC to detect hacked clock signals and respond as needed. In such an embodiment, a frequency monitor is implemented to detect on-die clock frequency hazards, an example implementation and respond to detected hacked clock signals. The frequency monitor couples two or more clock signals and determines whether a ratio between the clock signals match a received pre-defined frequency ratio.

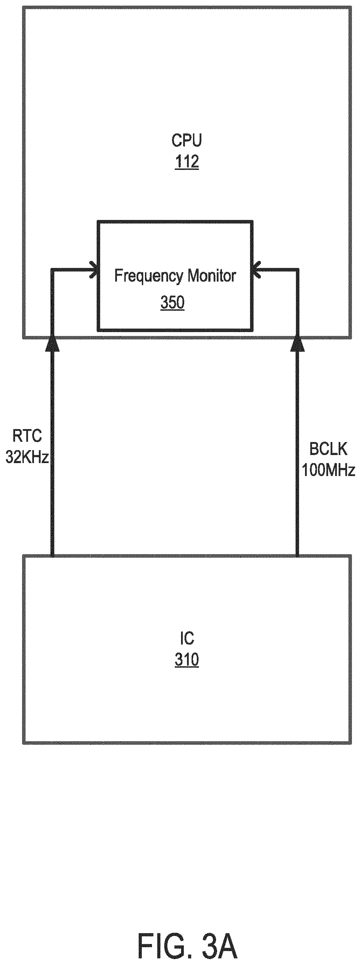

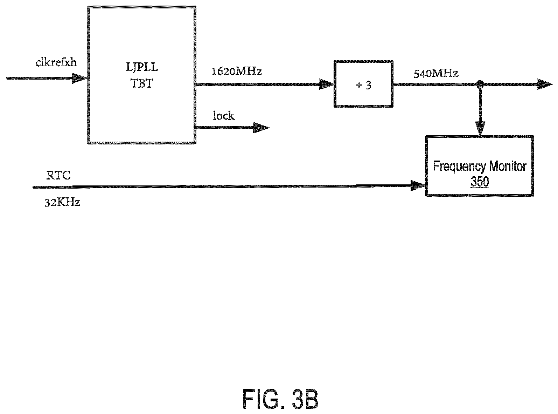

**Figures 3A&3B** illustrate embodiments of systems including a frequency monitor 350. **Figure 3A** illustrates one embodiment of an external clock embodiment in which frequency monitor 350 included within CPU 112. As shown in **Figure 3A,** frequency monitor 350 receives two clocks (RTC and BCLK) from an IC 310. Assuming that RTC has a frequency of 32KHz (e.g., slow clock), frequency monitor 350 may verify that the frequency of BCLK is 100MHz (e.g., fast clock), as discussed in more detail below. **Figure 3B** illustrates an internal clocks embodiment. In this embodiment, frequency monitor 350 verifies the clock is correct after a divider by 3. In such an embodiment, RTC is the slow clock received from IC 310 shown above, while the monitored clock is the output of the divider.

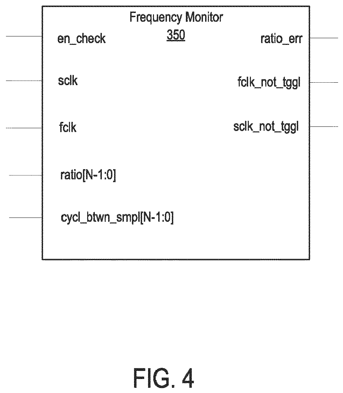

**Figure 4** illustrates one embodiment of frequency monitor 350. As shown in **Figure 4,** frequency monitor 350 comprises a logic circuit including various input/output (I/O) pins. In one embodiment, the I/O pins include a slower clock (sclk) input a faster clock (fclk) input and a ratio input that indicates an expected ratio between fclk frequency and sclk frequency. Additionally, an en check input indicates that both clocks are valid, and the ratio input is stable, while a cycl_btwn_smpl input indicates a quantity of sclk cycles to wait between the measurements. A ratio_err output indicates a frequency error. In embodiments, a ratio error indicates that a measured ratio is not equivalent to an expected ratio. A fclk_not_toggle output indicates that fclk is not toggling, while sclk_not_toggle output indicates that sclk is not toggling. In one embodiment, N represents a ratio width that derives a maximum allowed ratio between the input clocks. Although discussed above with reference to logic circuitry, other embodiments of frequency monitor 350 may be implemented in firmware, or a combination of firmware and logic circuitry.

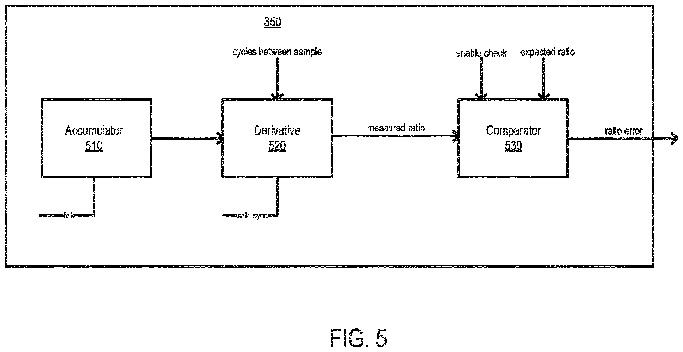

**Figure 5** illustrates frequency monitor 350 implemented in a ratio error embodiment. As shown in **Figure 5,** frequency monitor 350 includes accumulator 510, derivative 520 and comparator 530. In one embodiment, accumulator 510 comprises a cyclic counter that measures a quantity of cycles of fclk between a fixed number of rising edges of sclk, which is set by the cycl_btwn_smpl input. In this embodiment in which cycl_btwn_smpl = 1, frequency monitor 350 measures a quantity of cycles of fclk there are between 2 rising edges of sclk. However, in an instance in which the ratio between fclk and sclk is too small accumulator 510 makes the measurements less frequently than every rising edge of sclk. Thus, cycl_btwn_smpl=50 will be selected and accumulator 510 measures the quantity of cycles of fclk there are during 50 rising edges of sclk.

In one embodiment, the accumulator width covers the maximum frequencies ratio. In such an embodiment, 2 bits are included for wrap around correct functionality, such that:

$$WIDTH_{counter} = N + 2 = \left\lceil \log_2 \left( \max\left( \frac{fclk}{sclk} \right) \right) \right\rceil + 2$$

Thus, for an example using

$$sclk = 32KHz \text{ and } fclk_{max} = 2GHz,$$

$$WIDTH_{counter} = \left\lceil \log_2 \left( \frac{2GHz}{32KHz} \right) \right\rceil + 2 = 16 + 2 = 18$$

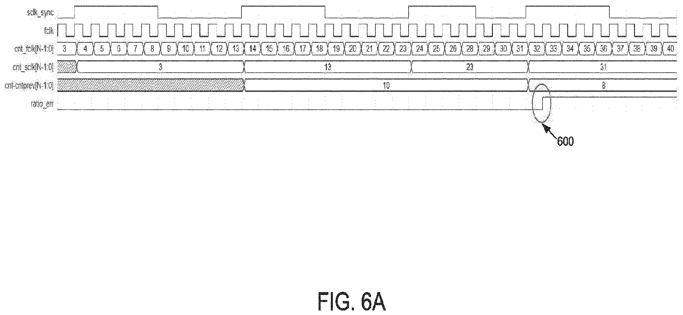

After the measurements are made by accumulator 510, derivative 520 applies a derivative on the sampled value and generates a ratio value between fclk and sclk. Comparator 530 compares the quantity of to an expected error margin to determine whether there is a ratio error. As discussed above, the enable check input indicates both clocks are valid, and the ratio input is stable. In one embodiment, the checking is disabled prior to changing the fclk frequency (e.g., PLL frequency for example) and to enable checking after the fclk is ready again and the new expected ratio is set. **Figure 6A** illustrates one embodiment of a ratio error waveform. In this embodiment, fclk is ten times faster than sclk and cycl_btwn_smpl = 1. As a result, the difference between 2 sclk samples is 10. When sclk rises after 8 cycles, the ratio_err rises to report that the ratio between the clocks is not as expected, as shown at point 610.

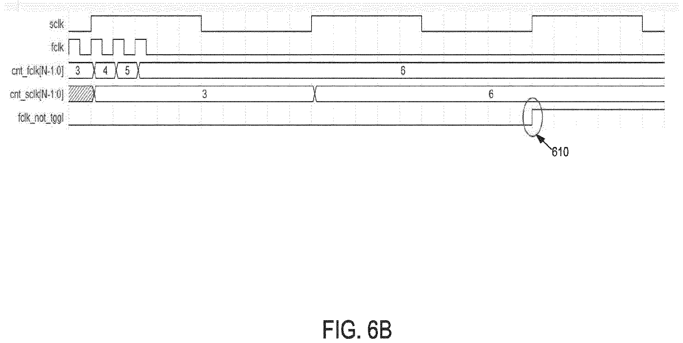

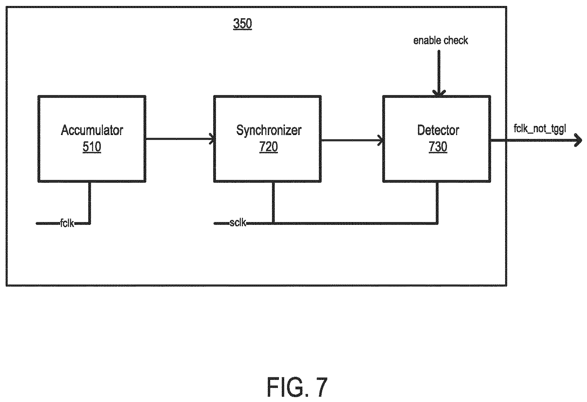

Frequency monitor 350 also detects whether the fclk is toggling. **Figure 7** illustrates such an embodiment of frequency monitor 350. In this embodiment, frequency monitor 350 also includes accumulator 510 that operates similar to discussed above with reference to **Figure 5.** A synchronizer 720 is coupled to accumulator 510 to synchronize fclk and sclk. A detector 730 is also included to detect whether fclk is toggling. In one embodiment, detector 730 checks the accumulator 510 value between 2 sclk rising edges to determine whether fclk is toggling. **Figure 6B** illustrates one embodiment of a fclk not Toggle Waveform. As shown in **Figure 6B,** the fclk has stopped and the sclk counter value is stuck at 6. As a result, Sclk sampled the same value twice, thus indicating an fclk not tggl indicator error at point 610.

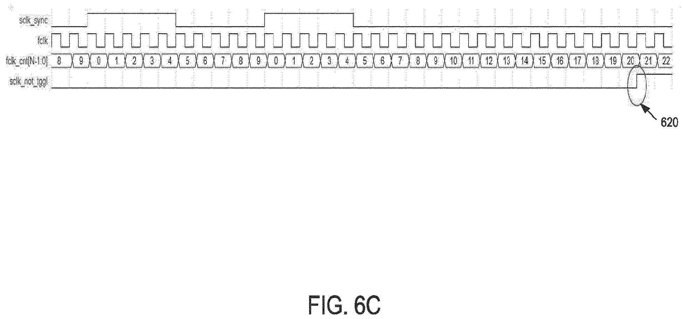

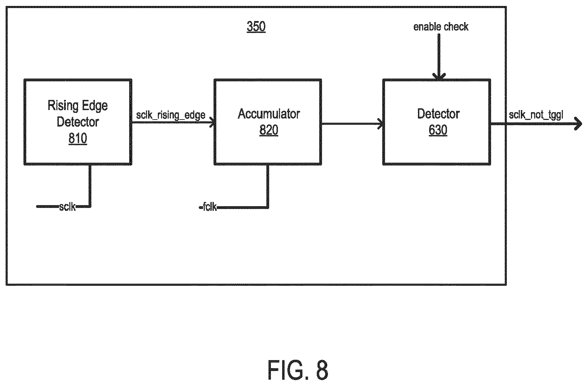

**Figure 8** illustrates another embodiment in which frequency monitor 350 detects whether the sclk is toggling. In this embodiment, an accumulator 820 is implemented as an fclk counter to detect whether sclk is not toggling. Unlike accumulator 510 discussed above, accumulator 820 comprises a non-cyclic counter that is initialized (or incremented) whenever sclk is rising as detected by a rising edge detector 810. In one embodiment, accumulator 820 count will not reach a value of $\left( \frac{fclk*cycl\_btwn\_smpl}{sclk} \right) * 2$ as long as sclk continues to toggle. However, detector 730 detects accumulator 820 reaching the $\left(\dfrac{fclk*\text{cycl\_btwn\_smpl}}{sclk}\right)*2$ value once sclk stops toggling, resulting in the sclk_not_tggl indication rising. **Figure 6C** illustrates one embodiment of a Sclk not Toggle Waveform. As shown in **Figure 6C,** fclk is 10 times faster than sclk and cycl_btwn_smpl = 1. Sclk has stopped and fclk counter reached $\left(\dfrac{fclk*\text{cycl\_btwn\_smpl}}{sclk}\right)*2 = 20$ . Thus, the sclk_not_tggl indication rises, as shown at point 630.

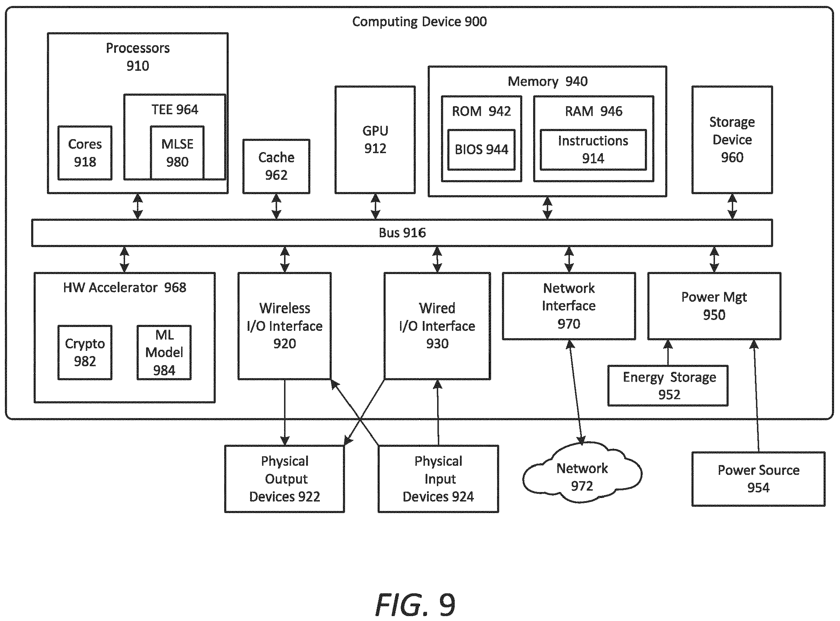

**Figure 9** is a schematic diagram of an illustrative electronic computing device. In some embodiments, the computing device 900 includes one or more processors 910 including one or more processors cores 918 and a TEE 964, the TEE including a machine learning service enclave (MLSE) 980. In some embodiments, the computing device 900 includes a hardware accelerator 968, the hardware accelerator including a cryptographic engine 982 and a machine learning model 984. In some embodiments, the computing device is to provide enhanced protections against ML adversarial attacks, as provided in **Figures 1-8.**

The computing device 900 may additionally include one or more of the following: cache 962, a graphical processing unit (GPU) 912 (which may be the hardware accelerator in some implementations), a wireless input/output (I/O) interface 920, a wired I/O interface 930, memory circuitry 940, power management circuitry 950, non-transitory storage device 960, and a network interface 970 for connection to a network 972. The following discussion provides a brief, general description of the components forming the illustrative computing device 900. Example, non-limiting computing devices 900 may include a desktop computing device, blade server device, workstation, or similar device or system.

In embodiments, the processor cores 918 are capable of executing machine-readable instruction sets 914, reading data and/or instruction sets 914 from one or more storage devices 960 and writing data to the one or more storage devices 960. Those skilled in the relevant art will appreciate that the illustrated embodiments as well as other embodiments may be practiced with other processor-based device configurations, including portable electronic or handheld electronic devices, for instance smartphones, portable computers, wearable computers, consumer electronics, personal computers ("PCs"), network PCs, minicomputers, server blades, mainframe computers, and the like.

The processor cores 918 may include any number of hardwired or configurable circuits, some or all of which may include programmable and/or configurable combinations of electronic components, semiconductor devices, and/or logic elements that are disposed partially or wholly in a PC, server, or other computing system capable of executing processor-readable instructions.

The computing device 900 includes a bus or similar communications link 916 that communicably couples and facilitates the exchange of information and/or data between various system components including the processor cores 918, the cache 962, the graphics processor circuitry 912, one or more wireless I/O interfaces 920, one or more wired I/O interfaces 930, one or more storage devices 960, and/or one or more network interfaces 970. The computing device 900 may be referred to in the singular herein, but this is not intended to limit the embodiments to a single computing device 900, since in certain embodiments, there may be more than one computing device 900 that incorporates, includes, or contains any number of communicably coupled, collocated, or remote networked circuits or devices.

The processor cores 918 may include any number, type, or combination of currently available or future developed devices capable of executing machine-readable instruction sets.

The processor cores 918 may include (or be coupled to) but are not limited to any current or future developed single- or multi-core processor or microprocessor, such as: on or more systems on a chip (SOCs); central processing units (CPUs); digital signal processors (DSPs); graphics processing units (GPUs); application-specific integrated circuits (ASICs), programmable logic units, field programmable gate arrays (FPGAs), and the like. Unless described otherwise, the construction and operation of the various blocks shown in Figure 9 are of conventional design. Consequently, such blocks need not be described in further detail herein, as they will be understood by those skilled in the relevant art. The bus 916 that interconnects at least some of the components of the computing device 900 may employ any currently available or future developed serial or parallel bus structures or architectures.

The system memory 940 may include read-only memory ("ROM") 642 and random access memory ("RAM") 946. A portion of the ROM 942 may be used to store or otherwise retain a basic input/output system ("BIOS") 944. The BIOS 944 provides basic functionality to the computing device 900, for example by causing the processor cores 918 to load and/or execute one or more machine-readable instruction sets 914. In embodiments, at least some of the one or more machine-readable instruction sets 914 cause at least a portion of the processor cores 918 to provide, create, produce, transition, and/or function as a dedicated, specific, and particular machine, for example a word processing machine, a digital image acquisition machine, a media playing machine, a gaming system, a communications device, a smartphone, or similar.

The computing device 900 may include at least one wireless input/output (I/O) interface 920. The at least one wireless I/O interface 920 may be communicably coupled to one or more physical output devices 922 (tactile devices, video displays, audio output devices, hardcopy output devices, etc.). The at least one wireless I/O interface 920 may communicably couple to one or more physical input devices 924 (pointing devices, touchscreens, keyboards, tactile devices, etc.). The at least one wireless I/O interface 920 may include any currently available or future developed wireless I/O interface. Example wireless I/O interfaces include, but are not limited to: BLUETOOTH®, near field communication (NFC), and similar.

The computing device 900 may include one or more wired input/output (I/O) interfaces 930. The at least one wired I/O interface 930 may be communicably coupled to one or more physical output devices 922 (tactile devices, video displays, audio output devices, hardcopy output devices, etc.). The at least one wired I/O interface 930 may be communicably coupled to one or more physical input devices 924 (pointing devices, touchscreens, keyboards, tactile devices, etc.). The wired I/O interface 930 may include any currently available or future developed I/O interface. Example wired I/O interfaces include, but are not limited to: universal serial bus (USB), IEEE 1394 ("FireWire"), and similar.

The computing device 900 may include one or more communicably coupled, non-transitory, data storage devices 960. The data storage devices 960 may include one or more hard disk drives (HDDs) and/or one or more solid-state storage devices (SSDs). The one or more data storage devices 960 may include any current or future developed storage appliances, network storage devices, and/or systems. Non-limiting examples of such data storage devices 960 may include, but are not limited to, any current or future developed non-transitory storage appliances or devices, such as one or more magnetic storage devices, one or more optical storage devices, one or more electro-resistive storage devices, one or more molecular storage devices, one or more quantum storage devices, or various combinations thereof. In some implementations, the one or more data storage devices 960 may include one or more removable storage devices, such as one or more flash drives, flash memories, flash storage units, or similar appliances or devices capable of communicable coupling to and decoupling from the computing device 900.

The one or more data storage devices 960 may include interfaces or controllers (not shown) communicatively coupling the respective storage device or system to the bus 916. The one or more data storage devices 960 may store, retain, or otherwise contain machine-readable instruction sets, data structures, program modules, data stores, databases, logical structures, and/or other data useful to the processor cores 918 and/or graphics processor circuitry 912 and/or one or more applications executed on or by the processor cores 918 and/or graphics processor circuitry 912. In some instances, one or more data storage devices 960 may be communicably coupled to the processor cores 918, for example via the bus 916 or via one or more wired communications interfaces 930 (e.g., Universal Serial Bus or USB); one or more wireless communications interfaces 920 (e.g., Bluetooth®, Near Field Communication or NFC); and/or one or more network interfaces 970 (IEEE 802.3 or Ethernet, IEEE 802.11, or Wi-Fi®, etc.).

Processor-readable instruction sets 914 and other programs, applications, logic sets, and/or modules may be stored in whole or in part in the system memory 940. Such instruction sets 914 may be transferred, in whole or in part, from the one or more data storage devices 960. The instruction sets 914 may be loaded, stored, or otherwise retained in system memory 940, in whole or in part, during execution by the processor cores 918 and/or graphics processor circuitry 912.

The computing device 900 may include power management circuitry 950 that controls one or more operational aspects of the energy storage device 952. In embodiments, the energy storage device 952 may include one or more primary (i.e., non-rechargeable) or secondary (i.e., rechargeable) batteries or similar energy storage devices. In embodiments, the energy storage device 952 may include one or more supercapacitors or ultracapacitors. In embodiments, the power management circuitry 950 may alter, adjust, or control the flow of energy from an external power source 954 to the energy storage device 952 and/or to the computing device 900. The power source 954 may include, but is not limited to, a solar power system, a commercial electric grid, a portable generator, an external energy storage device, or any combination thereof.

For convenience, the processor cores 918, the graphics processor circuitry 912, the wireless I/O interface 920, the wired I/O interface 930, the storage device 960, and the network interface 970 are illustrated as communicatively coupled to each other via the bus 916, thereby providing connectivity between the above-described components. In alternative embodiments, the above-described components may be communicatively coupled in a different manner than illustrated in Figure 9. For example, one or more of the above-described components may be directly coupled to other components, or may be coupled to each other, via one or more intermediary components (not shown). In another example, one or more of the above-described components may be integrated into the processor cores 918 and/or the graphics processor circuitry 912. In some embodiments, all or a portion of the bus 916 may be omitted and the components are coupled directly to each other using suitable wired or wireless connections.

Embodiments may be provided, for example, as a computer program product which may include one or more machine-readable media having stored thereon machine-executable instructions that, when executed by one or more machines such as a computer, network of computers, or other electronic devices, may result in the one or more machines carrying out operations in accordance with embodiments described herein. A machine-readable medium may include, but is not limited to, floppy diskettes, optical disks, CD-ROMs (Compact Disc-Read Only Memories), and magneto-optical disks, ROMs, RAMs, EPROMs (Erasable Programmable Read Only Memories), EEPROMs (Electrically Erasable Programmable Read Only Memories), magnetic or optical cards, flash memory, or other type of media/machine-readable medium suitable for storing machine-executable instructions.

Moreover, embodiments may be downloaded as a computer program product, wherein the program may be transferred from a remote computer (e.g., a server) to a requesting computer (e.g., a client) by way of one or more data signals embodied in and/or modulated by a carrier wave or other propagation medium via a communication link (e.g., a modem and/or network connection).

Throughout the document, term "user" may be interchangeably referred to as "viewer", "observer", "speaker", "person", "individual", "end-user", and/or the like. It is to be noted that throughout this document, terms like "graphics domain" may be referenced interchangeably with "graphics processing unit", "graphics processor", or simply "GPU" and similarly, "CPU domain" or "host domain" may be referenced interchangeably with "computer processing unit", "application processor", or simply "CPU".

It is to be noted that terms like "node", "computing node", "server", "server device", "cloud computer", "cloud server", "cloud server computer", "machine", "host machine", "device", "computing device", "computer", "computing system", and the like, may be used interchangeably throughout this document. It is to be further noted that terms like "application", "software application", "program", "software program", "package", "software package", and the **like,** may be used interchangeably throughout this document. Also, terms like "job", "input", "request", "message", and the like, may be used interchangeably throughout this document.

In various implementations, the computing device may be a laptop, a netbook, a notebook, an ultrabook, a smartphone, a tablet, a personal digital assistant (PDA), an ultra-mobile PC, a mobile phone, a desktop computer, a server, a set-top box, an entertainment control unit, a digital camera, a portable music player, or a digital video recorder. The computing device may be fixed, portable, or wearable. In further implementations, the computing device may be any other electronic device that processes data or records data for processing elsewhere.

The drawings and the forgoing description give examples of embodiments. Those skilled in the art will appreciate that one or more of the described elements may well be combined into a single functional element. Alternatively, certain elements may be split into multiple functional elements. Elements from one embodiment may be added to another embodiment. For example, orders of processes described herein may be changed and are not limited to the manner described herein. Moreover, the actions of any flow diagram need not be implemented in the order shown; nor do all of the acts necessarily need to be performed. Also, those acts that are not dependent on other acts may be performed in parallel with the other acts. The scope of embodiments is by no means limited by these specific examples. Numerous variations, whether explicitly given in the specification or not, such as differences in structure, dimension, and use of material, are possible. The scope of embodiments is at least as broad as given by the following claims.

Embodiments may be provided, for example, as a computer program product which may include one or more transitory or non-transitory machine-readable storage media having stored thereon machine-executable instructions that, when executed by one or more machines such as a computer, network of computers, or other electronic devices, may result in the one or more machines carrying out operations in accordance with embodiments described herein. A machine-readable medium may include, but is not limited to, floppy diskettes, optical disks, CD-ROMs (Compact Disc-Read Only Memories), and magneto-optical disks, ROMs, RAMs, EPROMs (Erasable Programmable Read Only Memories), EEPROMs (Electrically Erasable Programmable Read Only Memories), magnetic or optical cards, flash memory, or other type of media/machine-readable medium suitable for storing machine-executable instructions.

Some embodiments pertain to Example 1 that includes an apparatus comprising a frequency monitor circuitry to receive a first clock signal, a second clock signal and an expected frequency ratio, determine whether a ratio between the first clock signal and the second clock signal matches an expected an expected frequency ratio and generate an error signal upon a determination that the ratio between the first clock signal and the second clock signal does not match the expected frequency ratio

Example 2 includes the subject matter of Example 1, wherein the frequency monitor circuitry further to receive an enable signal to indicate that the first clock and the second clock are both valid.

Example 3 includes the subject matter of Examples 1 and 2, wherein the first clock comprises a fast clock and the second clock comprises a slow clock.

Example 4 includes the subject matter of Examples 1-3, wherein the frequency monitor circuitry comprises accumulator circuitry to count a quantity of cycles of the fast clock between a fixed number of edges of the slow clock.

Example 6 includes the subject matter of Examples 1-5, wherein the frequency monitor circuitry further comprises comparator circuitry coupled to the derivative circuitry to compare the ratio between the slow clock and the fast clock to the expected frequency ratio.

Example 7 includes the subject matter of Examples 1-6, wherein the frequency monitor circuitry further to detect whether the fast clock is toggling.

Example 8 includes the subject matter of Examples 1-7, wherein the frequency monitor circuitry comprises synchronization circuitry to synchronize the fast clock with the slow clock.

Example 9 includes the subject matter of Examples 1-8, wherein the frequency monitor circuitry further comprises detector circuitry coupled to the synchronization circuitry to determine whether the fast clock is toggling.

Example 10 includes the subject matter of Examples 1-9, wherein the frequency monitor circuitry further to detect whether the slow clock is toggling.

Example 11 includes the subject matter of Examples 1-10, wherein the frequency monitor circuitry comprises edge detector circuitry to detect edges of the slow clock.

Example 12 includes the subject matter of Examples 1-11, wherein the frequency monitor circuitry further comprises accumulator circuitry coupled to the to edge detector circuitry to increment a count whenever the edge detector circuitry detects that the slow clock is rising.

Example 13 includes the subject matter of Examples 1-12, wherein the frequency monitor circuitry further comprises detector circuitry to generate a signal upon detection that the count reaches a value.

Some embodiments pertain to Example 14 that includes a method comprising receiving a first clock signal, receiving a second clock signal, receiving an expected frequency ratio, determining whether a ratio between the first clock signal and the second clock signal matches the expected frequency ratio and generating an error signal upon a determination that the ratio between the first clock signal and the second clock signal does not match the expected frequency ratio.

Example 15 includes the subject matter of Example 14, further comprising receiving an enable signal to indicate that the first clock and the second clock are both valid.

Example 16 includes the subject matter of Examples 14 and 15, further comprising detecting whether the first clock is toggling.

Example 17 includes the subject matter of Examples 14-16, further comprising detecting whether the second clock is toggling.

Some embodiments pertain to Example 18 that includes a system comprising a first integrated circuit (IC) and a second IC, coupled to the first IC, including a frequency monitor circuitry to receive a first clock signal from the first IC, a second clock signal from the second IC and an expected frequency ratio, determine whether a ratio between the first clock signal and the second clock signal matches the expected frequency ratio and generate an error signal upon a determination that the ratio between the first clock signal and the second clock signal does not match the expected frequency ratio.

Example 19 includes the subject matter of Example 18, wherein the frequency monitor circuitry further to receive an enable signal to indicate that the first clock and the second clock are both valid.

Example 20 includes the subject matter of Examples 18 and 19, wherein the first clock comprises a fast clock and the second clock comprises a slow clock.

Some embodiments pertain to Example 21 that includes at least one computer readable medium having instructions stored thereon, which when executed by one or more processors, cause the processors to receive a first clock signal, receive a second clock signal, receive an expected frequency ratio, determine whether a ratio between the first clock signal and the second clock signal matches the expected frequency ratio and generate an error signal upon a determination that the ratio between the first clock signal and the second clock signal does not match the expected frequency ratio.

Example 22 includes the subject matter of Example 21, having instructions stored thereon, which when executed by one or more processors, further cause the processors to receive an enable signal to indicate that the first clock and the second clock are both valid.

The embodiments of the examples have been described above with reference to specific embodiments. Persons skilled in the art, however, will understand that various modifications and changes may be made thereto without departing from the broader spirit and scope as set forth in the appended claims. The foregoing description and drawings are, accordingly, to be regarded in an illustrative rather than a restrictive sense.

**Claims**

1. An apparatus comprising a frequency monitor circuitry to receive a first clock signal, a second clock signal and an expected frequency ratio, determine whether a ratio between the first clock signal and the second clock signal matches an expected the expected frequency ratio and generate an error signal upon a determination that the ratio between the first clock signal and the second clock signal does not match the expected frequency ratio.

2. The apparatus of claim 1, wherein the frequency monitor circuitry further to receive an enable signal to indicate that the first clock and the second clock are both valid.

3. The apparatus of claim 2, wherein the first clock comprises a fast clock and the second clock comprises a slow clock.

4. The apparatus of claim 3, wherein the frequency monitor circuitry comprises accumulator circuitry to count a quantity of cycles of the fast clock between a fixed number of edges of the slow clock.

5. The apparatus of claim 4, wherein the frequency monitor circuitry further comprises derivative circuitry coupled to the accumulator circuitry to generate the ratio between the slow clock and the fast clock.

6. The apparatus of claim 5, wherein the frequency monitor circuitry further comprises comparator circuitry coupled to the derivative circuitry to compare the ratio between the slow clock and the fast clock to the expected frequency ratio.

7. The apparatus of claim 3, wherein the frequency monitor circuitry further to detect whether the fast clock is toggling.

8. The apparatus of claim 7, wherein the frequency monitor circuitry comprises synchronization circuitry to synchronize the fast clock with the slow clock.

9. The apparatus of claim 8, wherein the frequency monitor circuitry further comprises detector circuitry coupled to the synchronization circuitry to determine whether the fast clock is toggling.

10. The apparatus of claim 3, wherein the frequency monitor circuitry further to detect whether the slow clock is toggling.

11. A method comprising:

   receiving a first clock signal;
   receiving a second clock signal;
   receiving an expected frequency ratio;
   determining whether a ratio between the first clock signal and the second clock signal matches the expected frequency ratio; and
   generating an error signal upon a determination that the ratio between the first clock signal and the second clock signal does not match the expected frequency ratio.

12. The method of claim 11, further comprising receiving an enable signal to indicate that the first clock and the second clock are both valid.

13. The method of claim 12, further comprising detecting whether the first clock is toggling.

14. The method of claim 12, further comprising detecting whether the second clock is toggling.

15. At least one computer readable medium having instructions stored thereon, which when executed by one or more processors, cause the processors to perform the method of claims 11-14.

COMPUTING DEVICE (e.g., SOC)
100

OPERATING SYSTEM (OS)
106

GRAPHICS DRIVER
116

GRAPHICS PROCESSING UNIT (GPU)
114

CENTRAL PROCESSING UNIT (CPU)   112

MEMORY
108

INPUT/OUTPUT (I/O) SOURCE(S)
(e.g., CAMERA(S), MICROPROCESSOR(S),
SPEAKER(S), SENSOR(S), DISPLAY SCREEN(S),
MEDIA PLAYER(S), ETC.)
104

FIG. 1

FIG. 2

FIG. 3A

clkrefxh

LJPLL
TBT

1620MHz

lock

÷ 3

540MHz

Frequency Monitor
350

RTC

32KHz

FIG. 3B

FIG. 4

350

cycles between sample

enable check    expected ratio

| Accumulator 510 | | Derivative 520 | measured ratio | Comparator 530 | ratio error |

fclk

sclk_sync

FIG. 5

FIG. 6A

FIG. 6B

FIG. 6C

350

enable check

| Accumulator 510 | Synchronizer 720 | Detector 730 | fclk_not_tggl |

fclk

sclk

FIG. 7

350

enable check

| Rising Edge Detector 810 | | Accumulator 820 | | Detector 630 |
|---|---|---|---|---|

sclk_rising_edge

sclk_not_tggl

sclk

fclk

FIG. 8

FIG. 9

EP 4 194 860 A1

Europäisches Patentamt
European Patent Office
Office européen des brevets

# EUROPEAN SEARCH REPORT

Application Number

EP 22 20 2072

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/094902 A1 (KANEKO TATSUYA [JP]) 28 March 2019 (2019-03-28) * abstract; claims 1-12; figures 1-22 * * paragraph [0007] – paragraph [0018] * * paragraph [0044] – paragraph [0221] * | 1-15 | INV. G01R23/02 G01R23/15 G06F1/12 H03K5/26 H03K5/19 |
| X | US 8 937 496 B1 (AHMAD SAGHEER [US] ET AL) 20 January 2015 (2015-01-20) * abstract; claims 1-20; figures 1-7 * * column 1, line 54 – column 2, line 17 * * column 2, line 48 – column 9, line 58 * | 1-15 | |
| X | US 7 472 305 B1 (HERSHMAN ZIV [IL] ET AL) 30 December 2008 (2008-12-30) * abstract; claims 1-36; figures 1A-2 * * column 3, line 7 – column 9, line 3 * | 1-15 | |
| A | JP S59 195166 A (SHIMADA RIKA KOGYO KK) 6 November 1984 (1984-11-06) * the whole document * | 1-15 | |
| A | GB 1 110 176 A (ASS ELECT IND) 18 April 1968 (1968-04-18) * abstract; claims 1-10; figures 1-18 * * page 1, left-hand column, line 36 – right-hand column, line 80 * * page 2, left-hand column, line 46 – page 8, right-hand column, line 110 * | 1-15 | TECHNICAL FIELDS SEARCHED (IPC) G01R G06F H03K |

The present search report has been drawn up for all claims

| Place of search | Date of completion of the search | Examiner |
|---|---|---|
| Munich | 18 April 2023 | Nadal, Rafael |

EPO FORM 1503 03.82 (P04C01)

**EP 4 194 860 A1**

## ANNEX TO THE EUROPEAN SEARCH REPORT
## ON EUROPEAN PATENT APPLICATION NO.

EP 22 20 2072

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2023

| Patent document cited in search report | | Publication date | Patent family member(s) | | Publication date |
|---|---|---|---|---|---|
| US 2019094902 | A1 | 28-03-2019 | EP 3451113 | A1 | 06-03-2019 |
| | | | JP 2017199104 | A | 02-11-2017 |
| | | | US 2019094902 | A1 | 28-03-2019 |
| | | | WO 2017187686 | A1 | 02-11-2017 |
| US 8937496 | B1 | 20-01-2015 | NONE | | |
| US 7472305 | B1 | 30-12-2008 | NONE | | |
| JP S59195166 | A | 06-11-1984 | NONE | | |
| GB 1110176 | A | 18-04-1968 | FR 1453318 | A | 23-09-1966 |
| | | | GB 1110176 | A | 18-04-1968 |

EPO FORM P0459

For more details about this annex : see Official Journal of the European Patent Office, No. 12/82

23